# EUROPEAN PATENT APPLICATION

(11) **EP 3 457 446 A1**
(43) Date of publication of application: **20.03.2019**
(21) Application number: 17190931.0
(22) Date of filing: 13.09.2017
(51) Int. Cl.: H01L 43/08, G06F 7/58, H03K 3/84

(54) **APPARATUS, IC AND SYSTEM FOR GENERATING REAL RANDOM NUMBERS**

(71) Applicant: Universität Bielefeld, 33615 Bielefeld (DE)
(72) Inventor: Reiss, Günter, 33605 Bielefeld (DE); Rott, Karsten, 33609 Bielefeld (DE)
(74) Representative: Michalski Hüttermann & Partner Patentanwälte mbB

(57) **Abstract**

The invention refers to an apparatus for generating a random number, the apparatus comprising a magnetic tunnel junction (1), comprising a first thin layer (2) of a ferromagnetic material, the first thin layer (2) defining a layer plane (8), a second thin layer (3) of a magnetic material arranged parallel to the layer plane (8) and a separating thin layer (4) arranged parallel to the layer plane (8) and located between the first layer (2) and the second layer (3), the separating thin layer (4) providing a tunnel barrier between the first thin layer (2) of ferromagnetic material and the second thin layer (3) of magnetic material, wherein the first thin layer (2) has a magnetization orientation, which is essentially perpendicular to the layer plane (8). The invention further refers to an integrated circuit and a system comprising such an apparatus.

## Description

The invention relates to an apparatus for generating a random number, the apparatus comprising a magnetic tunnel junction, comprising a first thin layer of a ferromagnetic material, the first thin layer defining a layer plane, a second thin layer / a second thin layer system of a magnetic material arranged parallel to the layer plane and a separating thin layer arranged parallel to the layer plane and located between the first layer and the second layer, the separating thin layer providing a tunnel barrier between the first thin layer of ferromagnetic material and the second thin layer / layer system of magnetic material. The invention further relates to an integrated circuit and a system comprising such an apparatus.

It is known to provide random number generators (RNG) in form of microscale on-chip devices. Such RNGs are well known in a number of security applications, for example for encryption keys etc.. The invention in particular provides an apparatur for generating real random numbers, contrary to most known devices which generally provide a generation of pseudo random numbers, as will be described in the following. Some of known RNGs are based on software applications and are provided by a source linked by data communication nets, e.g. internet, for example by the National Institute of Standarts and Technology (NIST). Such software-based RNGs have a significant energy consumption and require a high amount of space on chips. Further, standardized algorythms for RNGs may be threatened by safety risks. One of the main drawbacks of software-based RNGs is that they are suitable for providing a pseudo-random row of numbers but do not provide a real random row of numbers, which pseudo-random row is of limited quality as shown by tests directed to quality of randomness.

Beside software-based RNGs there are known RNGs which are based on the principle of magnetic tunnel junction (MTJ) but which provide certain drawbacks. Such magnetic tunnel junction devices usually comprise a sense layer of a ferromagnetic material, a reference layer of a magnetic material arranged parallel to the sense layer and a separating layer arranged between the sense layer and the reference layer. Most of such known RNGs based on MTJ are not suitable to provide Gaussian noise which is one of the most used methods for encryption of data communication. A further drawback of such RNGs is that they are not suited to controle the process of generation of random numbers such that the average of the variables and the variency may be changed dynamically.

One known solution to avoid the aforementioned drawbacks is provided in the form of spin transfer torque magnetic random access memory devices. Such devices use the randomness of writing of magnetical information. However, such devices have a relatively large energy consumption and are provided magnetically in-plane. RNG based on MTJ-Devices having its magnetization or magnetization direction in the plane of the thin film layers usually produce large stray fields at their edges. These stray fields lead to an increase of the magnetic coupling of the reference and the sense layer with decreasing device size. In addition, current necessary to switch the magnetization direction by spin transfer torque often does not scale down with the device size. Thus magnetically in-plane spin transfer torque magnetic random access memory devices have the drawback that miniaturization of such devices is very limited.

The US-patent US 9,110,746 B2 discloses a method and an apparatus for generating random numbers, comprising a magnetic tunnel junction having a free layer, a reference layer and a barrier layer between the free layer and the reference layer, wherein passing a current from a read operation through the magnetic tunnel junction causes a first magnetization orientation of the free layer to switch to a second magnetization orientation, wherein the switch in magnetization orientation causes a change in a resistance of the magnetic tunnel junction, and to periodically sample the resistance of the magnetic tunnel junction to generate a bit value for the random number. The magnetization orientation of the free layer is disclosed as being always in-plane, while the magnetiziation direction of the reference layer may be in-plane or out of plane. The change of magnetization orientation of the free layer is initiated or caused by spin polarization perpendicular to the direction of the in-plane magnetization orientation of the free layer. By providing the device and the free layer with a circular or essentially circular cross section in the plane of the layer and by providing the free layer with a sufficient thickness, there is provided a possibility of a pure thermal agitation of the oscillation of the magnetic movement.

In view of the aforementioned prior art, it is the object of the invention to provide an appartus for generating a real random number, which apparatus has better possibilities for minimization than known random number generating devices, and that allows a controlled generation of real random numbers by thermal activation only, without the need of applying any current imparting a spin transfer torque, is inexpensive, requires low power, generates data quickly and is impossible to be hacked.

According to the invention a solution for this problem is achieved by an apparatus according to claim 1, in particular by an apparatus for generating a random number, the apparatus comprising a magnetic tunnel junction, comprising a first thin layer of a ferromagnetic material, the first thin layer defining a layer plane, a second thin layer / layer system of a magnetic material or an arranged parallel to the layer plane and a separating thin layer arranged parallel to the layer plane and located between the first layer and the second layer, the separating thin layer providing a tunnel barrier between the first thin layer of ferromagnetic material and the second thin layer / layer system of magnetic material, which apparatus is characterized in that the first thin layer has an magnetization orientation, which is essentially perpendicular to the layer plane.

Further, a solution is achieved by an integrated circuit comprising an apparatus according to the invention, in particular comprising an apparatus according to one of the attached claims as well as by a system comprising a data storage, a processor coupled with the data storage and an apparatus according to the invention, in particular according to one of the attached claims, and an interface, preferably a wireless interface, for communication of the processor with another computing device. The invention further refers to the use of such an apparatus, such an integrated circuit and such a system for the generation of real random numbers.

The apparatus according to the invention is provided as a micro- or nano-scaled multi-layer-element (chip or system on chip) and comprises a number of layers arranged one on the other and essentially parallel to each other. The apparatus according to the invention can also be referred as a magnetic tunnel junction micro- or nano-scale element. In the apparatus the first thin layer provides a so called free layer or sense layer, which is designed to change magnetization direction, while the second thin layer provides a so called reference layer, which is designed to generally maintain its magnetization direction. The separating layer provides an insulating barrier between the first thin layer and the second thin layer and which is sufficiently thin such that electrons can tunnel through it from the first thin layer to the second thin layer and vice versa. The invention also comprises embodiments where the apparatus comprises several second thin layers forming a layer system of second thin layers of magnetic material.

A plane parallel to the layers, in particular parallel to the first thin layer generally is designated as the "layer plane". The direction of magnetization of the first thin layer according to the invention is oriented relativly to the layer plane. The orientation out-of-plane means an orientation out-of-layer plane, i.e. the orientation of the magnetic poles according to the invention is such that an imaginary line connecting the north pole and the south pole of the magnet is perpendicular to the layer plane. Contrary to that the state of art, in particular contrary to US 9,110,746 B2, where the orientation of the magnetization direction is in-plane, i.e. an imaginary line connecting the north pole and the south pole is parallel to and in the layer plane. Such out-of-plane orientation of the magnetization relative to the layer plane can be achieved by using magnetic materials with an intrinsic perpendicular magnetic anisotropy energy. Another realization is the use of magnetic interface anisotropy of the magnetic layers to the separating layer and / or to cover layers, that induces an out-of-plane magnetization of the magnetic layer. Example for layer system are CoFe/MgO, CoFeB/MgO or Co₂FeAl/MgO. To obtain the out-of-plane magnetization orientation according to the invention, in such layer systems the magnetic layer, in particular the first thin layer / sense layer must be very thin, for example have a film thickness of the magnetic layer between 0.7nm and 1.7nm, which is possible for the aforementioned known layer systems. Another reason why according to the invention the layers, in particular the first thin layer, are / is desiged thin in the aforementioned range is to reduce the layer volume. The effect achieved by this is that the energy necessary to switch / inverse the magnetization direction is decreased accordingly. For this reason the invention is able to provide a pure thermally activated switching / inversion of magnetization direction, in particular at temperature that is typical for device operation such as a temperature between - 20°C and +80°C.

For the film structure of US 9,110,746 B2 the increase of the magnetic coupling of the first and the second magnetic layer with decreasing size of the device will lead either to a shift of the hysteresis loop of the free layer (if the second layer is designed to maintain its magnetization direction) or to a convergence of the coercive fields (if both layer can switch their magnetizations). Thus for a size smaller than about 100nm the layer structure of US 9,110,746 B2 will not produce a completely random sequence of switching events and / or it will not produce a change of its resistance. According to the invention thin magnetic out-of-plane layers are used. This avoids any magnetic coupling between the layers and thus a complete random switching can be achieved, even at a size of the device below 100nm, which means that the inventions provides a very good miniaturization ability. In addition, the small film thickness provides the small magnetic volume necessary to achieve a pure thermally induced magnetic switching at typical temperature for device operation. Therefore, by the invention the first thin layer as well as the further layers (second thin layer, separating layer and further layers if present) can be provided very thin. In particular the thickness of the first thin layer of ferromagnetic material can be less than 10nm, preferably less than 2nm, more preferred 1nm, depending on the chosen material. There is no need (as for example in US 9,110,746 B2) to provide a certain minimum thickness of one of the layers, in particular to provide a certain minimum thickness of the first thin layer or the second thin layer, to provide an ability to change magnetic orientation by thermal activation only, without any further activation energy, in particular without the need to impart a spin transfer torque by an additional current passing through the apparatus. As a pure thermal activation of the first thin layer is sufficient to initiate changes of magnetization direction, the apparatus according to the invention requires very low energy supply, only. Further, the apparatus works without imparting any spin transfer torque, such that there is no preferred direction of magnetization orientation, which in result allows a generation of real random numbers (different from US 9,110, 746 B2 which when using spin transfer torque only allows a generation of pseudo-random numbers). It is a significant advantage of the invention that the apparatus works under pure thermal activation and at the same time allows a further minimization in comparison to the aforementioned known devices. It has to be taken into account that at a layer thickness of greater than 2nm as used and disclosed in US 9,110,746 B2 an out-of-plane magnetization is not possible, as the neccessary out-of-plane anisotropy cannot be provided.

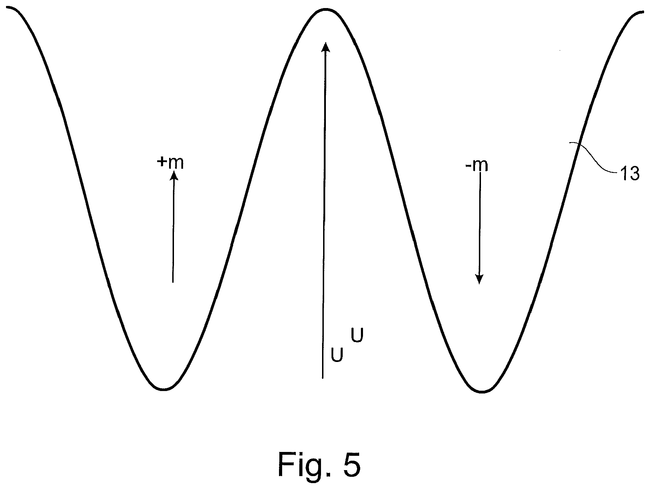

According to the invention there occurs a spontaneous and random thermical activated switching of the magnetization direction, i.e. inversion of magnetization direction. Such switching in particular occurs when the layer thickness of the first thin layer is low, for example less than 2nm, in particular 1nm. One can say that the first thin layer has a certain instabilty with regard to magnetization orientation that can be thermically activated. The physical background of this instability is the following: The first thin layer has a certain magnetical anisotrophy, such that according to the invention the magnetization direction is always held in a direction perpendicular to the layer plane. However, as shown in the attached figure 5, the direction of magnetization can change in both directions between two states, i.e. be inverted, in each of which the magnetization direction is perpendicular to the layer plane (N-S and S-N). This means that from a first state (e.g. N-S) of these two states the magnetization direction turns in the opposite direction into a second state (e.g. S-N) of these two states, and vice versa. Such a switching / inversion between the two states only occurs in cases where the thermical energy (Eₜₕ = k_{B} T , with Eₜₕ: thermal energy, k_{B:} Boltzmann constant, T: temperature) nearly corresponds or is equal to the magnetic anisotropy energy (E_{mag} = K_{eff} V , with E_{mag}: magnetic anisotropy energy, K_{eff}: effective magnetic anisotropy constant, V: Volume of first layer). According to one embodiment of the invention this inversion / switching of magnetization direction especially occurs when the first thin layer has only low thickness leading to a small volume and therefore small magnetic anisotropy energy Mag. Figure 5 shows an energy barrier U between the first state / magnetization direction +m and the second state / magnetization direction -m. The first state +m and the second state -m are energetically equal, but separated by the energy barrier U. In case of a sufficient rise of temperature (higher thermal energy), the energy barrier U can be overcome and changes between the two states +m and - m can randomly occur.

The first thin layer is provided from a ferromagnetic material and can be designated as providing a soft magnetic part of the apparatus. The second thin layer is provided such that it changes its magnetization direction less easy than the first thin layer and therefore can be designated as the hard magnetic part of the apparatus. The second thin layer for example can be provided by a hard magnetic material. Alternatively, the second thin layer can also be provided by a ferromagnetic material, in particular by the same material as the first thin layer. In this case the slower behaviour of the second layer with regard to its ability to change magnetization orientation is provided by a higher layer thickness than the first thin layer. As a further possibility, the second thin layer can be attached to an antiferromagnetic layer such as Ir-Mn or Pt-Mn such that an exchange bias effect provides a higher magnetic stability oft he second layer.

According to one embodiment the first thin layer may be a CoFeB-layer. Alternatively or additionally, the second thin layer / layer system is / comprises a CoFeB-layer. Alternatively or additionally, the separating layer may be a MgO-layer.

According to one embodiment of the invention the apparatus further may comprise a heating element, in particular a heating conductor or heating layer. Such a heating element is suitable for and configured to heating at least the first thin layer of ferromagnetic material. It may in particular further be configured to provide a temperature gradient between the first thin layer and the second thin layer / layer system. By heating of the apparatus with such a heating element a pure thermal activation can be provided wich is sufficient to initiate spontaneous changes of magnetization direction of the first thin layer. Further, the production of random numbers in this manner can be switched on or off and a bit-rate may be controlled.

According to a further embodiment the apparatus comprises a first contact electrically connected to the first thin layer of ferromagnetic material. Further, the apparatus may comprise a second contact electrically connected to the second thin layer / layer system. The first contact and/or the second contact may in particular be configured for measuring an electrical voltage or an electrical current between the first thin layer and the second thin layer / layer system. Alternatively, first contact and/or the second contact may in particular be configured for measuring a thermoelectrical voltage between the first thin layer and the second thin layer / layer system.

According to a further embodiment the apparatus may further comprise a circuit for generating a bias-voltage. Such a bias-voltage in particular may have an adjustable voltage level between the first thin layer and the second thin layer. Such a circuit in particular is used to regulate the frequency of each of the magnetic switching states of the first thin layer by adjusting the bias-voltage.

Further, the apparatus according to the invention may comprise a circuit for regulating the temperature provided by the heating conductor or the heating layer. By such a circuit in particular the frequency of each of the magnetic switching states of the first thin layer may be randomized. Further, the production of random numbers in this manner can be switched on or off and a bit-rate may be controlled.

According to one embodiment the apparatus may further comprise a current sensor for detecting a current in the first thin layer, wherein the current is generated by a bias-voltage.

In another embodiment the first and the second thin layer are designed to have different magnetic switching fields by choosing, for example, different film thicknesses of different materials such that both layers can change the direction of their magnetization.

Summarizing one can say that the invention provides the possibility of use of an apparatus, an integrated circuit as well as a system for the generation of real random numbers. In such systems random numbers may be in the form of real random "0" and "1" numbers or states which can be generated by an apparatus according to the invention, which therefore can be designated as a real random number generator (RND). The randomness of the "0" and "1" numbers is not predictable and un-clonable, as it purely depends from the switching / inversion of the first thin layer (free layer) between its two magnetization directions, which change in a purely real random manner. To provide a random number series, the switching states of the apparatus of the inventions are sampled periodically. The randomness of switching is not cloneable, enabeling the apparatus according to the invention for generation of real random numbers for cryptographic applications.

The invention will further be described without limiting effect by reference to the attached drawings, wherein the figures show:
Fig. 1 a schematic view of an examplary magnetic tunnel junction (MTJ) of an apparatus according to the invention,
Fig. 2 a graph showing the relation between current I and orientation of magnetization direction,
Fig. 3 a graph showing the relation between current I and time,
Fig. 4 a graph showing the relation between current I and voltage U and
Fig. 5 a graph showing the relation between magnetic anisotropy energy E_{mag} and magnetization direction.

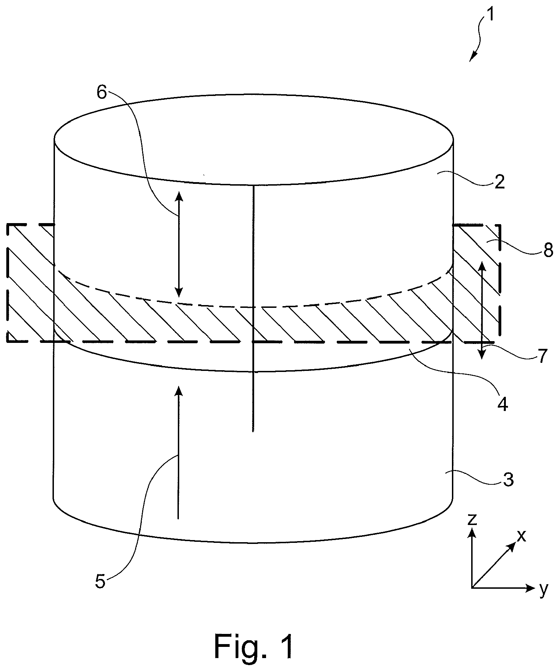

Figure 1 shows a schematic view of an examplary magnetic tunnel junction (MTJ) 1 comprised in an apparatus according to the invention. The MTJ 1 comprises a first thin layer 2 of a ferromagnetic material, here CoFeB. The MTJ 1 further comprises a second thin layer 3 of a magnetic material, here also CoFeB. The first thin layer 2 and the second thin layer 3 are arranged parallel to each other. The first thin layer 1 defines a layer plane (8), therefore the second thin layer 3 is also parallel to the layer plane (8). The MTJ 1 further comprises a separating thin layer 4 also arranged parallel to the layer plane (8) (and therefore to the first thin layer 2 and to the seond thin layer 3) and located between the first thin layer 2 and the second thin layer 3. The separating thin layer 4 provides a tunnel barrier between the first thin layer 2 and the second thin layer 3. While figure 1 shows only one single second thin layer 3, the invention also comprises embodiments where the MTJ 1 comprises several second thin layers 3 forming a layer system of second thin layers of magnetic material.

The magnetization orientation of the second thin layer 3 is fixed or pinned in a predermined direction, as indicated by a single arrow 5. The magnetization orientation of the first thin layer 2 is free to switch / rotate / inverse, as indicated by an double arrow 6. As also shown in figure 1, the magnetization direction of the first thin layer 2 is always perpendicular to the layer plane (8) (and therefore perpendicular to the first thin layer 2). The magnetization direction of the second thin layer 3 is also perpendicular the layer plane (8). Such an orientation of the magnetization orientation is also called out-of-plane with regard to the layer plane (8). For a better understanding, in figure 1 there is shown a coordinate system (x-y-z) indicating in-plane-directions x and y and out-of-plane-direction z.

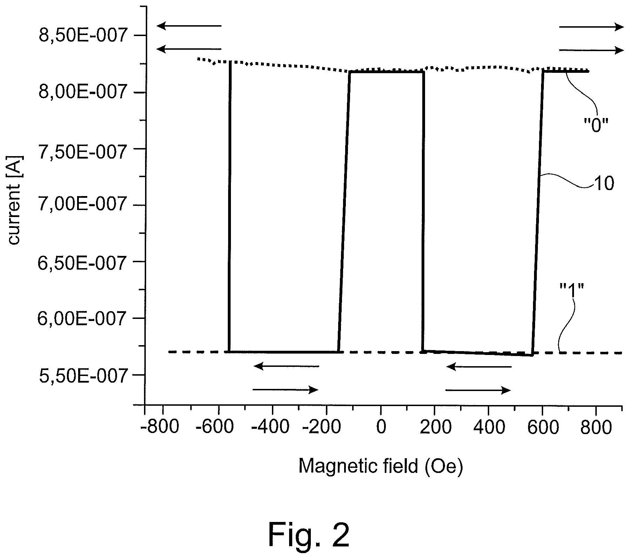

As indicated by another arrow 7, a voltage U is applied between the first thin layer 2 and the second thin layer 3 and a current I flows through the MTJ 1. The electric resistance of the MTJ 1 is R = U / I. With a constant voltage U the current I however also depends from the orientation of the magnetization directions of the first thin layer 2 and the second thin layer 3 to each other. This is caused by the magnetic tunnel resistance TMR of the MTJ 1, which is defined as TMR = (Rₐₚ - Rₚ) / Rₚ. The resistance of the MTJ 1 therefore is determined by the relative orientation of the magnetization directions of the first thin layer 2 on one hand and of the second thin layer 3 on the other hand. The MTJ 1 is in a low resistance state (and therefore the current I is high) when the magnetization directions of the first thin layer 2 and the second thin layer 3 are parallel to and unidirectional to each other. The MTJ 1 is in a high resistance state (and therefore the current I is low) when the magnetization directions of the first thin layer 2 and the second thin layer 3 are parallel to and bidirectional to each other. This circumstances are also shown in figure 2, where the "0"-state and the "1"-state are indicated and which shows a graph 10 indicating the relation of current I and magnetic field that is used to switch the magnetization directions in this exemplification.

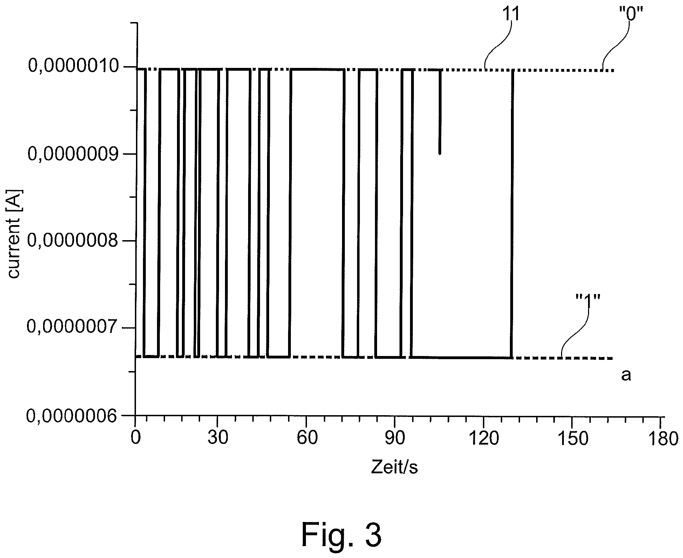

Figure 3 contains a graph 11 showing the relation between current I and time t at a constant voltage U of 10mV at a temperature of 31°C of the complete device, i.e. also of the first thin layer and unambigously indicates that the magnetization direction of the first thin layer 2 and therefore the resistance of the MTJ 1 randomly changes over the time. For providing a random number series, the resistance of the MTJ 1 is assigned to switching states, here a high resistance is assigned to a logical "1" and a low resistance is assigned to a logical "0". Real random numbers as well as a series of real random numbers can be created by periodically sampling the resistance and/or the current I of the MTJ 1. Periodically sampling in this context can mean repeatly sampling at constant time intervals or at changing (random) time intervals.

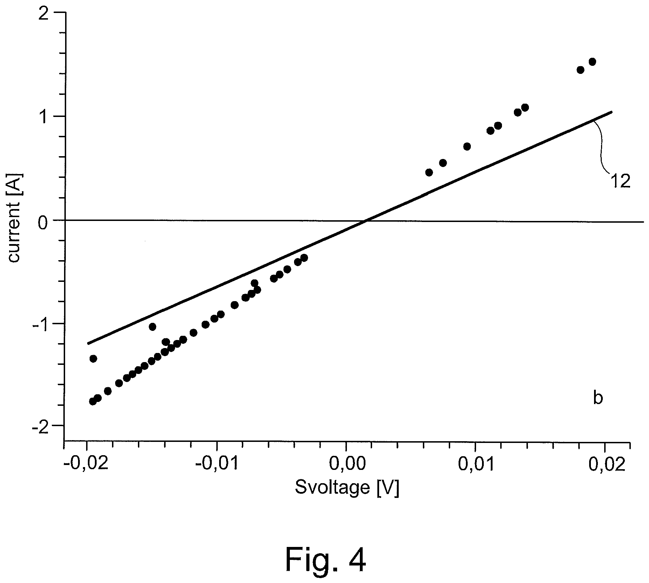

Figure 4 shows a graph 12 showing the relation between current I and voltage U at a measurement over a time of 11 hours and shows the changes of magnetization direction shown in figure 3.

Figure 5 shows a graph 13 indicating energetic states of the first thin layer 2. An energy barrier U is located between the first state / magnetization direction +m and the second state / magnetization direction -m, wherein the first state +m and the second state -m have a relative low energy level and the energy barrier U has a relativ high energy level. That is why resting in one the two states +m and -m is preferred. The first state +m and the second state -m are energetically equal, but separated by the energy barrier U. In case of a sufficient rise of temperature (higher thermal energy), the energy barrier U can be overcome and changes between the two states +m and -m can randomly occur.

## Claims

1. Apparatus for generating a random number, the apparatus comprising
a magnetic tunnel junction (1), comprising
a first thin layer (2) of a ferromagnetic material, the first thin layer (2) defining a layer plane (8),
a second thin layer (3) of a magnetic material, in particular of a ferromagnetic material, arranged parallel to the layer plane (8) and
a separating thin layer (4) arranged parallel to the layer plane (8) and located between the first layer (2) and the second layer (3),
the separating thin layer (4) providing a tunnel barrier between the first thin layer (2) of ferromagnetic material and the second thin layer (3) of magnetic material, **characterized in that** the first thin layer (2) has an magnetization orientation, which is essentially perpendicular to the layer plane (8).

2. Apparatus according to claim 1, wherein the thickness of the first thin layer (2) of ferromagnetic material is less than 10nm, preferably less than 2nm, more preferred 1nm.

3. Apparatus according to claim 1 or 2, wherein the first thin layer (2) is a CoFeB-layer and/or wherein the second thin layer (3) / second thin layer system (3) is / comprises a CoFeB-layer.

4. Apparatus according to one of the preceeding claims, wherein the separating layer (4) is a MgO-layer.

5. Apparatus according to one of the preceeding claims, further comprising a heating conductor or heating layer for heating at least the first thin layer (2) of ferromagnetic material and/or for providing a temperature gradient between the first thin layer (2) and the second thin layer (3).

6. Apparatus according to one of the preceeding claims, wherein the first thin layer (2) of ferromagnetic material is electrically connected to a first contact and wherein the second thin layer (3) is electrically connected to a second contact, for measuring an electrical voltage or an electrical current or a thermoelectrical voltage between the first thin layer (2) and the second thin layer (3).

7. Apparatus according to one of the preceeding claims, further comprising a circuit for generating a bias-voltage having an adjustable voltage level between the first thin layer (2) and the second thin layer (3).

8. Apparatus according to claim 5, further comprising a circuit for regulating the temperature provided by the heating conductor or the heating layer.

9. Apparatus according to one of the preceeding claims, further comprising a current sensor for detecting a current in the first thin layer (2), wherein the current is generated by a bias-voltage.

10. Integrated circuit comprising an appartus according to one of the preceeding claims.

11. System comprising a data storage, a processor coupled with the data storage and comprising an apparatus according to one of claims 1 to 9, and an interface, preferably a wireless interface, for communication of the processor with another computing device.

12. System according to claim 11, further comprising a display unit, preferably a touch sceen.
